# EUROPEAN PATENT SPECIFICATION

(11) **EP 4 113 095 B1**
(45) Date of publication and mention of the grant of the patent: **07.01.2026**
(21) Application number: 21761130.0
(22) Date of filing: 22.02.2021
(51) Int. Cl.: G01M 17/02, B60C 19/00, B60C 11/24

(54) **WEAR STATE PREDICTION METHOD, WEAR STATE PREDICTION DEVICE AND WEAR STATE PREDICTION PROGRAM**
VERSCHLEISSZUSTANDVORHERSAGEVERFAHREN, VERSCHLEISSZUSTANDVORHERSAGEVORRICHTUNG UND VERSCHLEISSZUSTANDVORHERSAGEPROGRAMM
PROCÉDÉ, DISPOSITIF ET PROGRAMME DE PRÉDICTION D'ÉTAT D'USURE

(30) Priority: 28.02.2020 JP 2020033208
(43) Date of publication of application: 04.01.2023
(73) Proprietor: Bridgestone Corporation, Tokyo 104-8340 (JP)
(72) Inventor: HANADA, Ryo, Tokyo 104-8340 (JP)
(74) Representative: Marks & Clerk LLP
(86) International application number: PCT/JP2021/006534
(87) International publication number: WO 2021/172248

(56) References cited:
- EP-A1- 3 378 679
- EP-A1- 3 470 814
- WO-A1-2017/156213
- WO-A1-2019/117232
- DE-A1- 102014 214 626
- GB-A- 2 559 142
- JP-A- 2002 131 191
- JP-A- 2013 113 724
- JP-A- 2017 156 295
- JP-A- 2017 187 418
- US-A1- 2017 113 494
- US-A1- 2019 255 891

## Description

### [Technical Field]

The present invention relates to a wear state prediction method, a wear state prediction device, and a wear state prediction program.

### [Background Art]

A technique for predicting a wear state of an aircraft tire has been known (Patent Literature 1). The method described in Patent Literature 1 acquires a plurality of wear energies corresponding to a plurality of traveling states (for example, touchdown running state, decelerating running state after touchdown, taxing state, etc.) divided according to the use conditions, and predicts the wear state of the aircraft tire based on the acquired wear energies. Attention is also drawn to the disclosure of WO2019/117232A1, which shows a wear prediction model for an aircraft tire. The disclosure of EP 3 378 679 A1 and JP 2002 131191 A is also relevant, both describing a wear prediction model for vehicle tires using temperature and weather forecast data as possible input values.

### [Citation List]

### [Patent Literature]

[Patent Literature 1]
Japanese Unexamined Patent Application Publication No. 2013 -113724

### [Summary of Invention]

### [Problems to be Solved by the Invention]

In recent years, the development of AI (machine learning, for example) has stimulated the analysis of big data. However, there has been little research on prediction methods using big data regarding wear conditions of aircraft tires.

It is therefore an object of the present invention to provide a wear state prediction method, a wear state prediction device, and a wear state prediction program for predicting an wear state of an aircraft tire using a model.

### [Means for Solving the Problem]

provided as claimed in claim 1. The invention is also provided respectively by a wear state prediction device and a wear state prediction program for predicting a wear state of an aircraft tire according to respective independent claims 8 and 9.

### [Effect of the Invention]

According to the present invention, the wear state of the aircraft tire can be predicted using the model.

### [Brief Description of Drawings]

FIG. 1 is a schematic diagram illustrating the relationship between the wear condition prediction device, the network, and the airline.
FIG. 2 is a schematic configuration diagram of the wear state prediction device according to an embodiment of the present invention.
FIG. 3 illustrates an example of machine learning according to an embodiment of the present invention.
FIG. 4 is a diagram for explaining an example of association between learning data and training data according to an embodiment of the present invention.
FIG. 5 is a sequence diagram illustrating an example of operation of the wear state prediction system according to an embodiment of the present invention.
FIG. 6 is a sequence diagram illustrating an example of operation of the wear state prediction system according to an embodiment of the present invention.
FIG. 7 illustrates an example of a method that takes into account air temperature after a day on which the wear rate is predicted.

### [Description of Embodiments]

Embodiments of the present invention will be described below with reference to the drawings. In the drawings, the same parts are denoted by the same reference numerals and the description thereof is omitted.

### (Configuration Example of Wear Condition Prediction System)

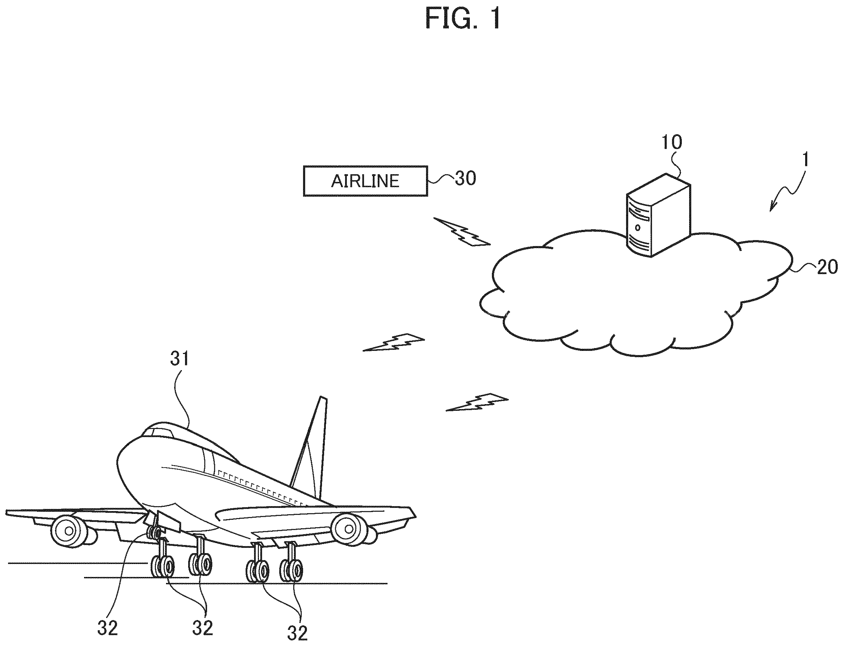

An example of the configuration of a wear state prediction system 1 will be described with reference to FIG. 1. As shown in FIG. 1, the wear state prediction system 1 includes a wear state prediction device 10, a network 20, and an airline (company) 30.

The wear state prediction device 10 performs bidirectional communication with the airline 30 via the network 20. Specifically, the wear state prediction device 10 acquires data relating to an aircraft 31 from the airline 30 via the network 20. The wear state prediction device 10 generates a machine learning model by using the acquired data, and predicts a wear state of an aircraft tire 32 mounted on the aircraft 31 by using the generated machine learning model. Details of the data acquired by the wear state prediction device 10 from the airline 30 will be described later. The network 20 is a communication network capable of transmitting and receiving data. For example, the network 20 is composed of various communication lines such as leased lines, public switched telephone networks, satellite communication lines, and mobile communication lines installed by telecommunications carriers.

In this embodiment, the aircraft tire 32 includes a tire mounted on a main gear and a tire mounted on a nose gear. A plurality of (for example, six) tires are mounted on the main gear. A plurality of tires (for example, two tires) are also mounted on the nose gear.

The wear state prediction device 10 is, for example, a general-purpose computer and includes a CPU, a ROM (Read Only Memory), and a RAM (Random Access Memory). The CPU reads the program stored in the ROM or the like into the RAM and executes the program. The wear state prediction device 10 may be a fixed type terminal device or a portable type terminal device (for example, a smartphone) which is easy to carry. The wear state prediction device 10 may be configured as a server of the management center.

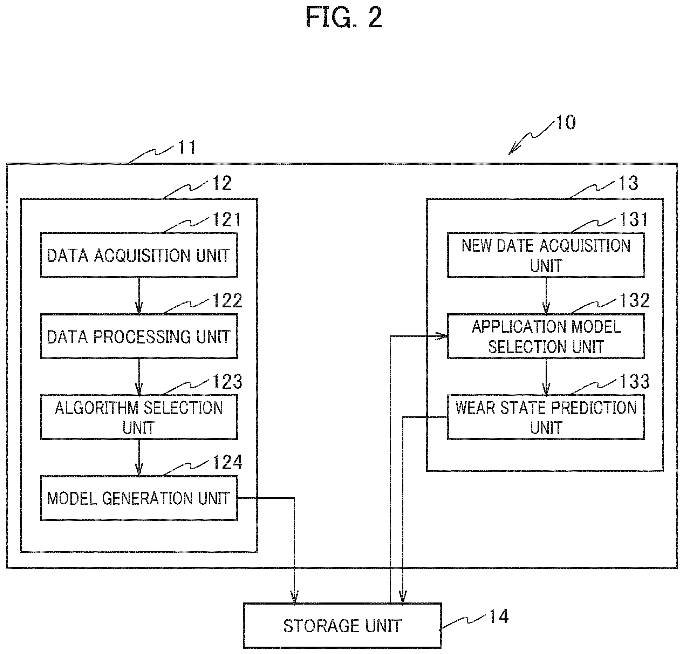

Next, with reference to FIG. 2, an example of the configuration of the wear state prediction device 10 will be described. As shown in FIG. 2, the wear state prediction device 10 includes a controller 11 (for example, a CPU) and a storage unit 14. The controller 11 includes a first processing function 12 and a second processing function 13 as a plurality of information processing functions. The first processing function 12 is further classified into a data acquisition unit 121, a data processing unit 122, an algorithm selection unit 123, and a model generation unit 124. The second processing function 13 is classified into a new data acquisition unit 131, an application model selection unit 132, and a wear state prediction unit 133.

The data acquisition unit 121 acquires data from the airline 30 via a communication unit (not shown). The communication unit is installed in the wear state prediction device 10, and is an interface connected to the network 20 for transmitting and receiving data to and from the airline 30. The data acquired by the data acquisition unit 121 from the airline 30 includes air temperature data of the aircraft 31, acceleration data of the aircraft 31, weight data of the aircraft 31, and data indicating a position where the aircraft tire 32 is mounted (hereinafter referred to simply as mounting position data).

Air temperature data of the aircraft 31 is temperature data measured by a sensor installed on the aircraft 31.

The acceleration data of the aircraft 31 includes acceleration data in the XYZ directions of the aircraft 31. The X direction is the longitudinal direction of the aircraft 31. The Y direction is the lateral direction of the aircraft 31. The Z direction is the vertical direction of the aircraft 31.

The data processing unit 122 processes the data acquired by the data acquisition unit 121. The details of the processing will be described later.

The algorithm selection unit 123 selects an algorithm to be used for generating a machine learning model. Algorithms include, for example, linear multiple regression, Lasso regression, nonlinear SVM, random forest, XGBoost, and the like.

The model generation unit 124 uses the algorithm selected by the algorithm selection unit 123 to machine learn data generated by the data processing unit 122 to generate a machine learning model. The model generation unit 124 generates a machine learning model for each algorithm. Thus, multiple machine learning models are generated. The generated machine learning model is stored in a storage device 14.

A new data acquisition unit 131 acquires new data to be inputted to the machine learning model generated by the model generation unit 124 from the airline 30. The new data acquired by the new data acquisition unit 131 from the airline 30 is the same as the data acquired by the data acquisition unit 121 from the airline 30 in attributes (Temperature, acceleration, etc.), structure (every 1 second described later), etc., but the data itself is different.

The application model selection unit 132 reads the machine learning model generated by the model generation unit 124 from the storage unit 14, and evaluates the prediction performance of the red machine learning model. The application model selection unit 132 selects a machine learning model having the highest prediction performance based on the evaluation result.

The wear state prediction unit 133 inputs the new data acquired by the new data acquisition unit 131 to the machine learning model selected by the application model selection unit 132 to predict the wear state. Wear states include wear amount and wear rate. Details of the wear amount and the wear rate will be described later. The data relating to the predicted wear state is stored in the storage unit 14.

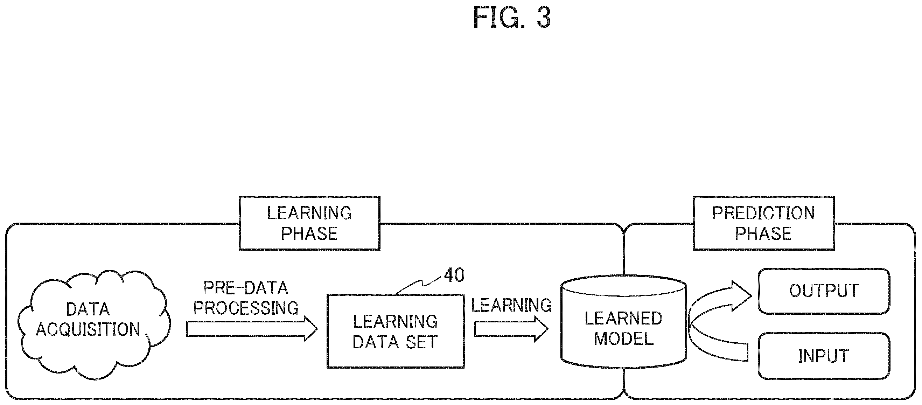

Next, with reference to FIGs. 3 to 4, a method of generating a machine learning model and a method of predicting a wear state using the generated machine learning model will be described.

As shown in Figure 3, machine learning is divided into a learning phase and a prediction phase. In the learning phase, features are extracted from vast amounts of data (big data) to create machine learning models. In the prediction phase, new data is fed into the generated machine learning model and results are output. In FIG. 3, the acquired data is data acquired from the airline 30 as described above, and includes air temperature data of the aircraft 31, acceleration data of the aircraft 31, weight data of the aircraft 31, mounting position data, and the like.

In statistics, data input for machine learning is sometimes called explanatory variables. In this embodiment, the air temperature data of the aircraft 31, the acceleration data of the aircraft 31, the weight data of the aircraft 31, the mounting position data, and the like are explanatory variables. Data output from the learned model may also be referred to as objective variables. In this embodiment, the wear state of the aircraft tire 32 is an objective variable.

Machine learning includes supervised learning with and without training data. In this embodiment, supervised learning is used. The training data means so-called "correct answer data". Supervised learning is a method using a learning data set (indicated by reference numeral 40 in FIG. 3) in which "input data" and "correct answer data" are set. As shown in FIG. 3, in this embodiment, big data is processed to generate a learning data set 40 before machine learning is performed. Such data processing before machine learning is referred to as pre-data preprocessing.

Next, the pre-data preprocessing will be described. In this embodiment, the pre-data preprocessing means aggregation of data and association of aggregated data with training data. Such association is sometimes called labeling. The data acquisition unit 121 acquires data from the airline 30 for each flight. When data is acquired from a sensor attached to an aircraft as a data structure for one flight, data is stored every second for example. That is, temperature data, acceleration data, and the like are stored every second. Therefore, even for a single flight, the amount of data is enormous.

Usually, the number of flights from the time when the aircraft tire 32 is mounted on the airframe to the time when it is dismounted is several hundred. Hereinafter, the number of flights from the time when the aircraft tire 32 is mounted on the airframe to the time when it is dismounted may be expressed as all flights. In the present embodiment, the machine learning data is data of all flights (several hundred flights) from the time when the aircraft tire 32 is mounted on the airframe to the time when it is dismounted. With respect to such big data, the training data (wear rate based on wear amount) to be the linking destination is one value. The wear amount means the amount of wear of the aircraft tire 32 from the time when the aircraft tire 32 is mounted on the airframe to the time when it is dismounted, and the unit is mm. When X (mm) is the groove depth of a new aircraft tire 32 and Y (mm) is the groove depth when the aircraft tire 32 is dismounted, X-Y (mm) is the wear amount. Typically, the amount of wear is measured after the aircraft tire 32 has been dismounted, so there is only one value.

In this embodiment, the wear rate is used as the training data. The relationship between the wear amount and the wear rate will now be described. In this embodiment, the wear rate is defined as the amount of wear of the aircraft tire 32 in one landing. The unit of wear rate is expressed as mm/LD. The wear rate is calculated by dividing the wear amount measured after the aircraft tire 32 is dismounted by all the landing times. The wear rate thus calculated is used as the training data. In this embodiment, the number of landings and the number of flights have the same meaning.

However, the definition of the wear rate is not limited to the above. The wear rate may be defined as the amount of wear relative to the taxiing distance. Taxing means that the aircraft 31 travels on the ground (mainly on a runway) using the power of the aircraft 31. The wear rate is calculated by dividing the amount of wear measured after the aircraft tire 32 has been dismounted by the taxing mileage on all flights. The taxing mileage in one flight is the sum of the taxing mileage at the departure airport and the taxing mileage at the arrival airport. This sum is typically several kilometers.

The wear rate may also be defined as a parameter of the amount of wear divided by the cumulative value for the flight. Accumulated values for flights include, by way of example, the number of landings and taxiing mileage described above. The cumulative value for the flight may include a total value of representative values (for example, average values) of acceleration of each flight and a total value of weight of each flight.

Hereinafter, by way of example, the wear rate will be described as an amount (mm/LD) of wear of the aircraft tire 32 in one landing. Of course, as described above, the wear rate may be a value acquired by dividing the amount of wear by the taxing mileage, or a parameter acquired by dividing the amount of wear by the cumulative value for the flight. As described above, since the wear amount is one value, the wear rate calculated by the wear amount is also one value.

Since the training data (wear rate) is one value, it is necessary to aggregate various data associated with the training data into one value. Therefore, the data processing section 122 collects the temperature data, the acceleration data, the weight data and the like into one value. Since the mounting position data is a fixed value, aggregation is unnecessary.

First, an example of an aggregation method of temperature data will be described. The data processing unit 122 averages temperature data in one flight to calculate average temperature data in one flight. The data processing unit 122 repeats this processing to calculate average temperature data for every flight (first flight, second flight ··· 100th flight ···). Then, the data processing unit 122 averages the average temperature data for all the flights to calculate the average temperature data (one value) for all the flights (first to several hundred times). This average processing is an example of the aggregation method and is not a mandatory processing. As described below, the representative value of the explanatory variable is not limited to the mean value, but may be the median value or the mode value.

As described above, when data is acquired from the sensor mounted on the aircraft, temperature data is stored every second. That is, the stored temperature data includes temperature data when the aircraft 31 is stopped, temperature data when the aircraft 31 is traveling, temperature data when the aircraft 31 is flying, and the like. When aggregating the temperature data, the data processing unit 122 may select and use a portion of the data according to the state of the aircraft 31. For example, temperature data when the aircraft 31 is in flight need not be used. In other words, the data processing unit 122 may calculate the average temperature data (one value) by averaging a part of the temperature data of each flight.

Next, an example of the aggregation method of acceleration data will be described. The acceleration data includes acceleration data in the XYZ directions as described above. Therefore, the data processing unit 122 aggregates the acceleration data in the X direction, the acceleration data in the Y direction, and the acceleration data in the Z direction. Here, acceleration data in the X direction will be described as a representative example.

The data processing unit 122 calculates average acceleration data (X direction) in a single flight by averaging after square sum of acceleration data (X direction) in a single flight. The data processing unit 122 repeats this processing to calculate average acceleration data (X direction) for every flight (first flight, second flight ··· 100th flight ···). Then, the data processing unit 122 averages the average acceleration data (X direction) for all the flights to calculate the average acceleration data (one value in the X direction) for all the flights (first to several hundred times). Since the Y direction and the Z direction are the same, description thereof will be omitted.

Next, an example of the weight data aggregation method will be described. The data processing unit 122 extracts the maximum value from the weight data in one flight. The data processing unit 122 repeats this processing to extract the maximum value of the weight data for every flight (first flight, second flight ··· 100th flight ···). Then, the data processing unit 122 averages the maximum values of the weight data for all the flights to calculate the average weight data (one value) for all the flights (first to several hundred times).

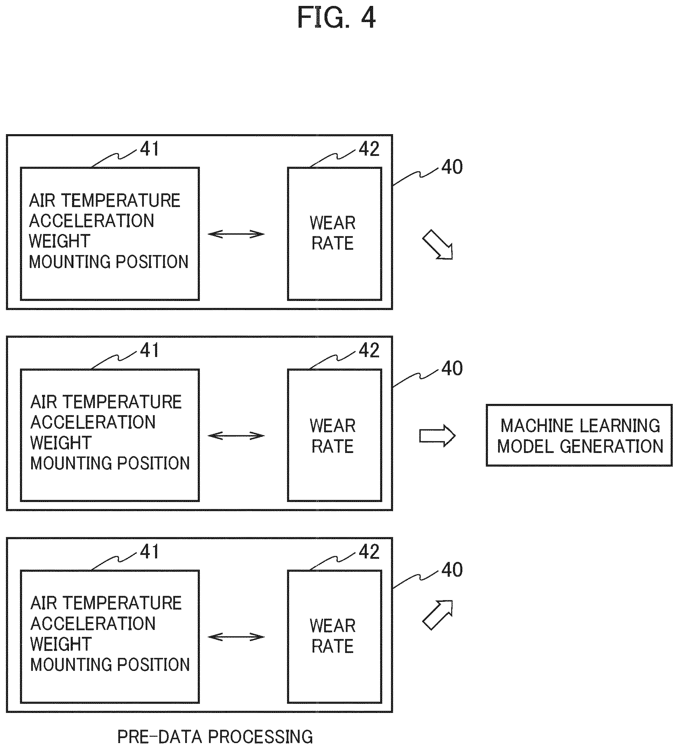

In this way, the data processing unit 122 calculates the average temperature data, average acceleration data (X, Y, Z), and average weight data of all flights as one value. As shown in FIG. 4, these 1 values (learning data 41) are associated with training data 42 (wear rate) to generate the learning data set 40. Since the learning data set 40 is generated for each aircraft tire, a plurality of learning data sets 40 are usually generated.

The algorithm selection unit 123 selects an algorithm to be used for generating a machine learning model. Algorithms include linear multiple regression, Lasso regression, nonlinear SVM, random forest, XGBoost, and the like, as described above. However, any algorithm capable of supervised learning may be used. Since these algorithms are well known, a detailed description thereof will be omitted.

As shown in FIG. 4, the model generation unit 124 uses the algorithm selected by the algorithm selection unit 123 to perform machine learning on the learning data set 40 generated by the data processing unit 122 to generate a machine learning model. In this embodiment, the linear multiple regression, Lasso regression, nonlinear SVM, random forest, and XGBoost described above are used as the algorithms.

In general, the predictive performance of a machine learning model is evaluated by one or a combination of items that describe the performance of the algorithm, such as coefficient of determination (R²), mean square error (RMSE), and so on. In this embodiment, the closer the value of the wear rate, which is an objective variable, is to the measured value, the higher the performance is evaluated. The application model selection unit 132 selects a machine learning model having the highest prediction performance based on the evaluation result.

As shown in FIG. 3, the wear state prediction unit 133 inputs new data to the machine learning model (learned model) selected by the application model selection unit 132 to predict the wear rate. The new data is acquired by the new data acquisition unit 131. The new data is the data from the time when the aircraft tire 32 is mounted on the airframe to the time when the wear rate is predicted.

In the present embodiment, average temperature data, average acceleration data, average weight data, mounting position data, and the like are used as explanatory variables for machine learning, but in these explanatory variables, the contribution ratio to the objective variable is not uniform. The contribution ratio indicates the magnitude of the effect of each explanatory variable on the objective variable and the larger the effect on the objective variable, the more important the explanatory variable.

The explanatory variable (average temperature data, average acceleration data, average weight data, mounting position data, etc.) in this embodiment is an explanatory variable that does not accumulate. In other words, in this embodiment, the accumulated explanatory variables are not used, and only the non-accumulated explanatory variables are used. The accumulated explanatory variable is, for example, the taxing mileage described above. The reason for not using cumulative explanatory variables is that the accuracy of the machine learning model is lower when using cumulative explanatory variables.

The inventor analyzed the contribution ratio to the object variable for each of the explanatory variables. As a result, the inventor found that the contribution ratio of the average temperature data was the highest among the explanatory variables compared with other data. The inventor also found that the explanatory variable with the next highest contribution ratio after the average temperature data was the average acceleration data. This indicates that if average temperature data is used as an explanatory variable when generating a machine learning model for predicting wear rate, a highly accurate model can be obtained. It is also shown that a more accurate model can be obtained by using the average acceleration data as explanatory variables in addition to the average temperature data.

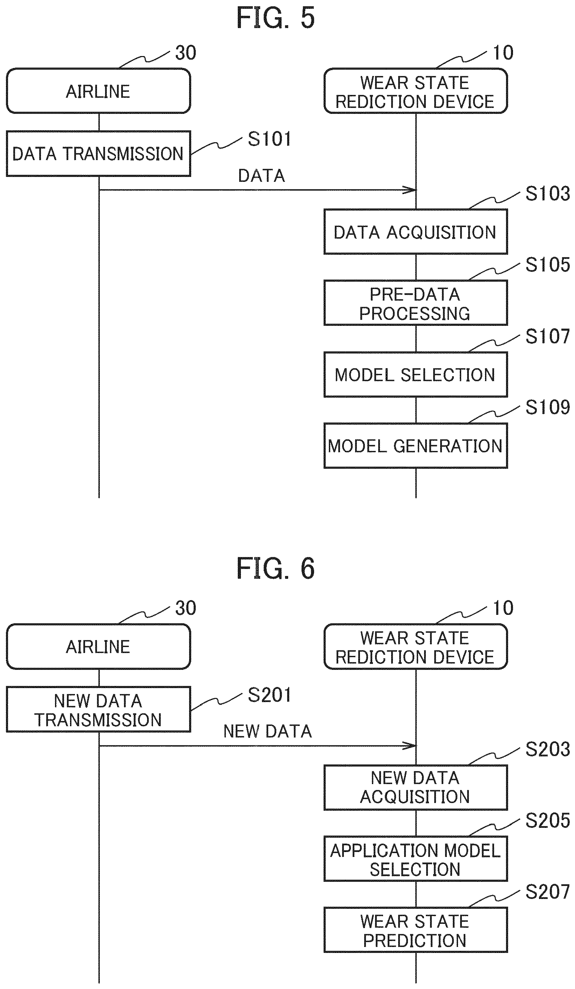

Next, an operation example of the wear state prediction system 1 will be described with reference to the sequence diagram of FIGs. 5 to 6.

In step 101, air temperature data of the aircraft 31, acceleration data of the aircraft 31, weight data of the aircraft 31, mounting position data, and the like are transmitted from the airline 30.

In step S 103, the data acquisition unit 121 acquires the data transmitted in step S 101. The processing proceeds to step 105, and the data processing unit 122 processes the data acquired in step 103. Specifically, the data processing unit 122 aggregates the temperature data, the acceleration data, the weight data, and the like into one value. The data processing unit 122 associates aggregated data (learning data 41) with training data 42 to generate a learning data set 40.

The processing proceeds to step 107, and the algorithm selection unit 123 selects an algorithm (Linear multiple regression, Lasso regression, nonlinear SVM, random forest, XGBoost, etc.) to be used for generating the machine learning model.

The process proceeds to step S 109, and the model generating unit 124 uses the algorithm selected in step S 107 to perform machine learning on the learning data set 40 generated in step S 105 to generate a machine learning model.

In step 201, air temperature data of the aircraft 31, acceleration data of the aircraft 31, weight data of the aircraft 31, mounting position data, and the like are transmitted from the airline 30. The data transmitted in step 201 is new data used to predict the wear rate.

In step 203, the new data acquisition unit 131 acquires the new data transmitted in step 201. The processing proceeds to step 205, and the application model selection unit 132 evaluates the prediction performance of the machine learning model generated in step 109, and selects the machine learning model having the highest prediction performance.

The processing proceeds to step S 207, and the wear state prediction unit 133 inputs the new data acquired in step S 203 to the machine learning model selected in step S 207 to predict the wear rate.

### (Effect)

As described above, according to the wear state prediction method according to the present embodiment, the following effects can be obtained.

The wear state prediction device 10 generates a model (machine learning model) for predicting a wear state as an objective variable by using a predetermined algorithm in which air temperature data of an aircraft 31 acquired from an airline 30 is set as an explanatory variable. The wear state prediction device 10 inputs the temperature data to the generated model to predict the wear state. As described above, the inventor found that the contribution ratio of the temperature data (mean temperature data) was the highest among the explanatory variables compared with other data. By using the temperature data with the highest contribution ratio, it is possible to generate a machine learning model with high predictive performance. The wear state can be accurately predicted by using a machine learning model having high prediction performance. The wear state indicates, for example, the wear rate obtained by dividing the wear amount of the aircraft tire 32 by the number of flights.

As described above, the inventor has found that the explanatory variable having the second highest contribution rate after the temperature data (average temperature data) is the acceleration data (average acceleration data). By using the temperature data and the acceleration data having a higher contribution ratio than other data, it is possible to generate a machine learning model having a higher prediction performance and to predict the wear state with higher accuracy.

### [DELETED]

In the above-described embodiment, it has been explained that the new data (data at the time of prediction) input to the machine learning model is data from the time when the aircraft tire 32 is mounted on the airframe to the time when the prediction of the wear rate is performed. On the other hand, the data for generating the machine learning model (data at the time of learning) is the data from the time when the aircraft tire 32 is mounted on the aircraft to the time when it is dismounted. The date on which the wear rate is predicted does not necessarily coincide with the date on which the aircraft tire 32 is dismounted. Therefore, the number of data from the day when the aircraft tire 32 is mounted on the airframe to the day when the wear rate is predicted does not necessarily coincide with the number of data from the day when the aircraft tire 32 is mounted on the airframe to the day when it is dismounted. As a result, a highly accurate result may not be obtained.

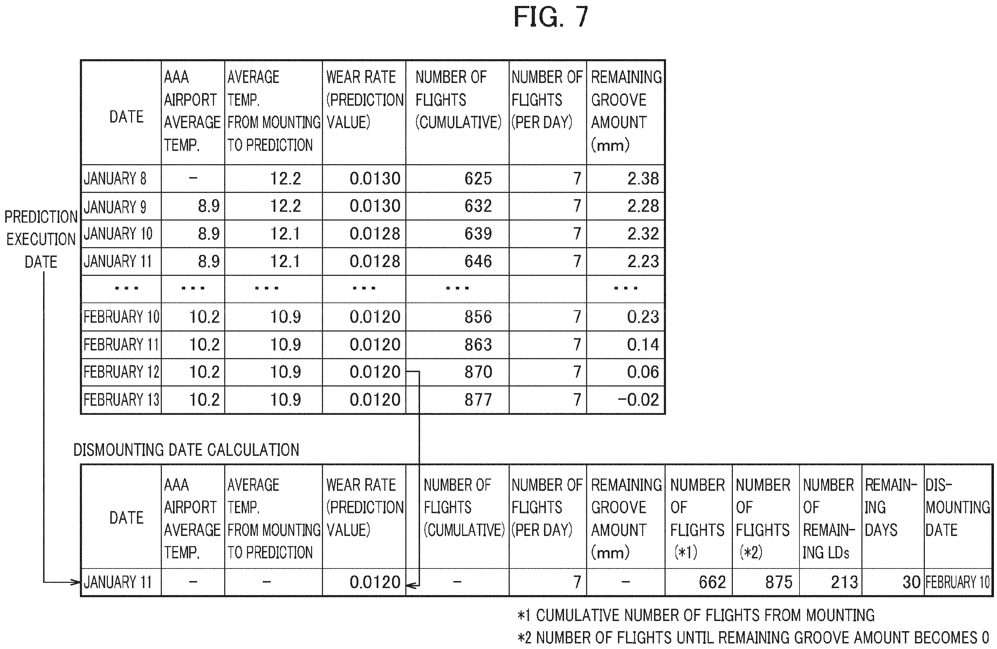

Therefore, for the average temperature data having the highest contribution ratio to the objective variable, the temperature after the day on which the prediction of the wear rate is performed may be considered. An example of a method in which air temperature after a day on which the wear rate is predicted is considered will be described with reference to FIG. 7.

January 8 shown in FIG. 7 is the day on which the latest data exists, and January 11 is the day on which the wear rate is predicted (hereinafter, it may be simply referred to as prediction execution date). The latest data is the latest data transmitted from the airline 30.

When the wear rate is predicted, i.e., on January 11, there are no data for January 9 to 11th. In this case, the data acquisition unit 121 first aggregates data from the date when the aircraft tire 32 is mounted on the airframe to January 8. Of the aggregated data, the average temperature data (the first temperature data) is 12.2 degrees as shown in FIG. 7. The wear state prediction unit 133 inputs aggregated data to a machine learning model to predict a wear rate. The predicted wear rate is 0.0130 as shown in FIG. 7.

The wear state prediction unit 133 calculates a wear amount by multiplying the predicted wear rate (0.0130) by the number of flights (625 times). The wear state prediction unit 133 subtracts the calculated wear amount from the groove depth of a new aircraft tire 32 and calculates a remaining groove amount indicating the remaining groove depth. The calculated remaining groove amount is 2.38 mm as shown in FIG. 7. The wear state prediction unit 133 may calculate the amount of wear by multiplying the predicted wear rate by the cumulative value of the flight.

When the remaining groove amount is larger than 0, the wear state prediction unit 133 generates data for the next day (January 9). As shown in FIG. 7, since the remaining groove amount (2.38 mm) on January 8 is greater than 0, the wear state prediction unit 133 generates data for the next day (January 9). The wear state prediction unit 133 acquires an average temperature (second temperature data) in January at the AAA airport where the aircraft 31 arrives, and stores it in a database. As a result, 8.9 degrees Celsius (refer to FIG. 7) is input to the average air temperature of AAA airport as of January 9. Next, the wear state prediction unit 133 updates the average temperature data from the day when the aircraft tire 32 is mounted on the airframe to January 9 using the temperature data of 8.9 degrees. The updated mean temperature data is 12.2 degrees as shown in FIG. 7.

The wear state prediction unit 133 inputs data including the updated average air temperature data to a machine learning model and predicts the wear rate again. The predicted wear rate is 0.0130 as shown in FIG. 7. A wear state prediction unit 133 calculates a wear amount by multiplying the predicted wear rate (0.0130) by the number of flights (632 times). A wear state prediction unit 133 subtracts the calculated wear amount from the groove depth of a new aircraft tire 32 to calculate the remaining groove amount. The calculated remaining groove amount is 2.28 mm as shown in FIG. 7.

Since the remaining groove amount (2.28 mm) on January 9 is greater than 0, the wear state prediction unit 133 generates data for the next day (January 10). The same processing is repeatedly performed until the remaining groove amount becomes 0 or less. The average temperature in February at AAA airport is 10.2 degrees Celsius.

As shown in FIG. 7, the day on which the remaining groove amount becomes 0 or less is February 13 (remaining groove amount is -0.02.). After the day (February 13) on which the remaining groove amount becomes 0 or less is calculated, the wear state prediction unit 133 calculates the day on which the aircraft tire 32 is dismounted. Next, an example of the calculation method of the date when the aircraft tire 32 is dismounted will be described.

First, the wear state prediction unit 133 calculates the number of flights (*2 shown in FIG. 7) until just before the remaining groove amount becomes 0 using the groove depth of the aircraft tire 32 when it is new and the wear rate (0.0120) on February 12. The wear state prediction unit 133 subtracts (875 -662) the cumulative number of flights (*1 shown in FIG. 7) from the number of flights until the remaining groove amount becomes 0 when the aircraft tire 32 is mounted on the prediction execution date (January 11), and calculates the remaining number of possible landings (the number of remaining LDs in FIG. 7: 213). The remaining number of possible landing times means the number of possible use times of the aircraft tire 32.

The wear state prediction unit 133 divides the remaining number of possible landing times by the number of flights per day (7 times) to calculate the number of days for which the aircraft tire 32 can be used (30 days remaining in FIG. 7). Then, the wear state prediction unit 133 calculates February 10, 30 days after January 11, as a day for dismounting the aircraft tire 32.

In this way, by taking into account the air temperature after the day on which the wear rate is predicted (after the time of prediction), it is possible to accurately predict the wear rate.

Further, by using a highly accurate wear rate, it is possible to accurately calculate the date on which the aircraft tire 32 is to be dismounted. Normally, when replacing the aircraft tire 32, the amount of wear is manually measured by an operator, and the tire is replaced when the amount of wear reaches a predetermined value. However, if more than a certain number of aircraft tires 32 are intensively replaced at the same replacement time, there is a risk that replacement work may be delayed or inventory shortage may occur. On the other hand, according to the wear state prediction device 10, the date on which the aircraft tire 32 is dismounted is calculated with high accuracy, so that efficient operation of the replacement work can be performed.

In the above embodiment, the temperature data of the aircraft 31 is used as an explanatory variable for generating the machine learning model. The temperature data of the aircraft 31 is temperature data measured by the sensor installed in the aircraft 31. However, the explanatory variables used to generate the machine learning model are not limited to temperature data measured by sensors installed on the aircraft 31. The explanatory variable used to generate the machine learning model may be the air temperature data of the airport.

The method of acquiring the air temperature data of an airport is not particularly limited, but the air temperature data observed at a fixed point may be acquired, and the air temperature data disclosed by an administrative organization (for example, the Japan Meteorological Agency) may be acquired. The aggregation method of the air temperature data of the airport is the same as the aggregation method of the air temperature data of the aircraft 31 described above. In other words, the air temperature data of the airport is averaged and aggregated into one value in the same manner as the air temperature data of the aircraft 31.

However, the method of aggregating the air temperature data of the aircraft 31 and the air temperature data of the airport is not limited to the average. Air temperature data of the aircraft 31 and air temperature data of the airport used as explanatory variables may be median values or mode values.

Air temperature data for the aircraft 31 includes both temperature data measured by the sensor installed on the aircraft 31 and air temperature data at the airport.

Further, the data processing unit 122 may divide and aggregate the period in which the temperature data is stored when aggregating the temperature data of the aircraft 31 and the temperature data of the airport. The data processing unit 122 may, for example, divide the period in which the temperature data is stored into the first half and the second half and aggregate them. As described above, the number of flights from the time when the aircraft tire 32 is mounted on the airframe to the time when it is dismounted is several hundred. Here, it is assumed that the number of flights from the time when the aircraft tire 32 is mounted on the airframe to the time when it is dismounted is 500.

In this case, the data processing unit 122 may divide the period in which the temperature data is stored into the first half (1st to 250th) and the second half (251st to 500th) and aggregate them. As a result, the first half average temperature data (one value) and the second half average temperature data (one value) are obtained as aggregated data. The data associated with the training data may be the first half average temperature data or the second half average temperature data. The same effect as that described above can be obtained by dividing and aggregating the period in which the temperature data are stored. The data to be divided is not limited to the temperature data, and the period in which the acceleration data is stored may be divided. The division method is not limited to the first half and the second half, but may be three divisions.

Further, the data processing unit 122 may, when aggregating the air temperature data of the aircraft 31 and the air temperature data of the airport, classify the periods in which the air temperature data are stored into 2 or more different periods and aggregate them by using a plurality of classified periods. As an example of the method of classifying into 2 or more periods, the data processing unit 122 can classify the period in which the temperature data is stored into the entire period (1st to 500th) and the first half (1st to 250th). The data processing unit 122 averages respective average temperature data of a plurality of classified periods (whole period and first half) to acquire average temperature data (one value) of a plurality of classified periods (whole period and first half). Even if the periods in which the temperature data are stored are classified into a plurality of periods and aggregated, effects similar to those described above can be obtained. The data to be classified is not limited to the temperature data, and the period in which the acceleration data is stored may be classified into a plurality of periods. That is, the data processing unit 122 may classify the periods in which the explanatory variables having the same attribute are stored into 2 or more different periods and aggregate them by using a plurality of classified periods.

### [Explanation of Reference Numerals]

1) Wear state prediction system
10 Wear state prediction device
11 Controller
12 First processing function
13 Second processing function
14 Storage unit
20 Network
30. Airline
31 Aircraft
32 Aircraft tire
121 Data acquisition unit
122 Data processing unit
123 Algorithm selection unit
124 Model generation unit
131 New data acquisition unit
132 Application model selection unit
133 Wear state prediction unit

## Claims

1. A wear state prediction method for predicting a wear state of an aircraft tire (32), comprising the steps of:
generating a model for predicting the wear state as an objective variable by using a predetermined algorithm in which air temperature data relating to an aircraft (31) acquired in advance, the air temperature data being measured by a sensor installed on the aircraft (31) or being the air temperature data at an airport, is set as an explanatory variable; and
inputting the air temperature data to the generated model and predicting the wear state, wherein
the air temperature data relating to the aircraft (31) is defined as first air temperature data;
when predicting the wear state, data including second air temperature data that is after a prediction time and the first air temperature data are inputted to the model and the wear state is predicted.

2. The wear state prediction method according to claim 1, wherein the wear state is wear rate defined as a parameter of wear amount of the aircraft tire (32) divided by the cumulative value for flights.

3. The wear state prediction method according to claim 2, wherein the wear amount is predicted by multiplying the cumulative value for the flights to the wear rate predicted.

4. The wear state prediction method according to claim 2 or 3, wherein a usable number of times of the aircraft tire (32) is predicted by using a groove depth of the aircraft tire (32) acquired in advance when the aircraft tire (32) is new and the wear rate predicted.

5. The wear state prediction method according to any one of claims 1 to 4, wherein the air temperature data relating to the aircraft (31) is acquired by a sensor installed on the aircraft.

6. The wear state prediction method according to any one of claims 1 to 5, wherein the model is generated by using the predetermined algorithm using the air temperature data relating to the aircraft (31) and acceleration data of the aircraft (31) acquired in advance as the explanatory variables.

7. The wear state prediction method according to claim 5, wherein the air temperature data related to the aircraft (31) is an average of a part of air temperature data for each flight.

8. A wear state prediction device (10) for predicting a wear state of an aircraft tire (32), comprising:
a model generation unit (124) that generates a model for predicting the wear state as an objective variable by using a predetermined algorithm in which air temperature data relating to an aircraft (31) acquired in advance, the air temperature data being measured by a sensor installed on the aircraft (31) or being the air temperature data at an airport, is set as an explanatory variable; and
a prediction unit that inputs the air temperature data to the model generated by the model generation unit and predicts the wear state, wherein
the air temperature data relating to the aircraft (31) is defined as first air temperature data; and
the prediction unit inputs data including second air temperature data that is after a prediction time and the first air temperature data to the model, and predicts the wear state.

9. A wear state prediction program for predicting a wear state of an aircraft tire, the wear state prediction program causes a computer of the terminal device to execute the steps of:
generating a model for predicting the wear state as an objective variable by using a predetermined algorithm in which air temperature data relating to an aircraft (31) acquired in advance, the air temperature data being measured by a sensor installed on the aircraft (31) or being the air temperature data at an airport, is set as an explanatory variable; and
inputting the air temperature data to the model and predicting the wear state, wherein
the air temperature data relating to the aircraft (31) is defined as first air temperature data; and
when predicting the wear state, data including second air temperature data that is after a prediction time and the first air temperature data are inputted to the model and the wear state is predicted.

## Patentansprüche

1. Verschleißzustandvorhersageverfahren zum Vorhersagen eines Verschleißzustands eines Flugzeugreifens (32), das die folgenden Schritte umfasst:
Erzeugen eines Modells zum Vorhersagen des Verschleißzustands als Zielvariable unter Verwendung eines vorbestimmten Algorithmus, in dem im Voraus erfasste Lufttemperaturdaten bezüglich eines Flugzeugs (31), wobei die Lufttemperaturdaten von einem am Flugzeug (31) installierten Sensor gemessen werden oder die Lufttemperaturdaten eines Flughafens sind, als erklärende Variable festgelegt werden; und
Eingeben der Lufttemperaturdaten in das erzeugte Modell und Vorhersagen des Verschleißzustands, wobei
die Lufttemperaturdaten des Flugzeugs (31) als erste Lufttemperaturdaten definiert sind;
beim Vorhersagen des Verschleißzustands Daten, einschließlich zweiter Lufttemperaturdaten, die nach einer Vorhersagezeit vorliegen, und die ersten Lufttemperaturdaten in das Modell eingegeben werden und der Verschleißzustand vorhergesagt wird.

2. Verschleißzustandvorhersageverfahren nach Anspruch 1, wobei der Verschleißzustand die Verschleißrate ist, die als Parameter eines Verschleißbetrags des Flugzeugreifens (32) geteilt durch den kumulierten Wert für Flüge definiert ist.

3. Verschleißzustandvorhersageverfahren nach Anspruch 2, wobei der Verschleißbetrag vorhergesagt wird, indem der kumulative Wert für die Flüge mit der vorhergesagten Verschleißrate multipliziert wird.

4. Verschleißzustandvorhersageverfahren nach Anspruch 2 oder 3, wobei eine verwendbare Einsatzzahl des Flugzeugreifens (32) vorhergesagt wird, indem eine Rillentiefe des Flugzeugreifens (32), die im Voraus erfasst wird, als der Flugzeugreifen (32) neu war, und die vorhergesagte Verschleißrate verwendet werden.

5. Verschleißzustandvorhersageverfahren nach einem der Ansprüche 1 bis 4, wobei die Lufttemperaturdaten bezüglich des Flugzeugs (31) von einem im Flugzeug installierten Sensor erfasst werden.

6. Verschleißzustandvorhersageverfahren nach einem der Ansprüche 1 bis 5, wobei das Modell unter Verwendung des vorbestimmten Algorithmus erzeugt wird, der die Lufttemperaturdaten bezüglich des Flugzeugs (31) und Beschleunigungsdaten des Flugzeugs (31), die im Voraus erfasst werden, als erklärende Variablen verwendet.

7. Verschleißzustandvorhersageverfahren nach Anspruch 5, wobei die Lufttemperaturdaten bezüglich des Flugzeugs (31) ein Durchschnitt eines Teils von Lufttemperaturdaten für jeden Flug sind.

8. Verschleißzustandsvorhersagevorrichtung (10) zum Vorhersagen eines Verschleißzustands eines Flugzeugreifens (32), umfassend:
eine Modellerzeugungseinheit (124), die ein Modell zum Vorhersagen des Verschleißzustands als Zielvariable erzeugt, indem sie einen vorbestimmten Algorithmus verwendet, in dem im Voraus erfasste Lufttemperaturdaten bezüglich eines Flugzeugs (31), wobei die Lufttemperaturdaten von einem am Flugzeug (31) installierten Sensor gemessen werden oder die Lufttemperaturdaten eines Flughafens sind, als erklärende Variable festgelegt werden; und
eine Vorhersageeinheit, die die Lufttemperaturdaten in das von der Modellerzeugungseinheit erzeugte Modell eingibt und den Verschleißzustand vorhersagt, wobei
die Lufttemperaturdaten bezüglich des Flugzeugs (31) als erste Lufttemperaturdaten definiert sind; und
die Vorhersageeinheit Daten, einschließlich zweiter Lufttemperaturdaten, die nach einer Vorhersagezeit vorliegen, und die ersten Lufttemperaturdaten in das Modell eingibt und den Verschleißzustand vorhersagt.

9. Verschleißzustandsvorhersageprogramm zum Vorhersagen eines Verschleißzustands eines Flugzeugreifens, wobei das Verschleißzustandsvorhersageprogramm einen Computer der Endgerätevorrichtung veranlasst, die folgenden Schritte auszuführen:
Erzeugen eines Modells zum Vorhersagen des Verschleißzustands als Zielvariable unter Verwendung eines vorbestimmten Algorithmus, in dem im Voraus erfasste Lufttemperaturdaten bezüglich eines Flugzeugs (31), wobei die Lufttemperaturdaten von einem am Flugzeug (31) installierten Sensor gemessen werden oder die Lufttemperaturdaten eines Flughafens sind, als erklärende Variable festgelegt werden; und
Eingeben der Lufttemperaturdaten in das Modell und Vorhersagen des Verschleißzustands, wobei
die Lufttemperaturdaten bezüglich des Flugzeugs (31) als erste Lufttemperaturdaten definiert sind; und
beim Vorhersagen des Verschleißzustands Daten, einschließlich zweiter Lufttemperaturdaten, die nach einer Vorhersagezeit vorliegen, und die ersten Lufttemperaturdaten in das Modell eingegeben werden und der Verschleißzustand vorhergesagt wird.

## Revendications

1. Procédé de prédiction d'état d'usure pour prédire un état d'usure d'un pneu d'aéronef (32), comprenant les étapes consistant à :
générer un modèle de prédiction de l'état d'usure en tant que variable objective en utilisant un algorithme prédéterminé dans lequel des données de température de l'air se rapportant à un aéronef (31) acquises à l'avance, les données de température de l'air étant mesurées par un capteur installé sur l'aéronef (31) ou étant les données de température de l'air à un aéroport, sont définies comme une variable explicative ; et
saisir les données de température de l'air dans le modèle généré et prédire l'état d'usure, dans lequel
les données de température de l'air se rapportant à l'aéronef (31) sont définies comme premières données de température de l'air ;
lors de la prédiction de l'état d'usure, des données incluant des secondes données de température de l'air qui sont postérieures à un temps de prédiction et aux premières données de température de l'air sont saisies dans le modèle et l'état d'usure est prédit.

2. Procédé de prédiction d'état d'usure selon la revendication 1, dans lequel l'état d'usure est un taux d'usure défini comme un paramètre de quantité d'usure du pneu d'aéronef (32) divisé par la valeur cumulée pour les vols.

3. Procédé de prédiction d'état d'usure selon la revendication 2, dans lequel la quantité d'usure est prédite en multipliant la valeur cumulative des vols par le taux d'usure prédit.

4. Procédé de prédiction d'état d'usure selon la revendication 2 ou 3, dans lequel un nombre de fois utilisable du pneu d'aéronef (32) est prédit en utilisant une profondeur de rainure du pneu d'aéronef (32) acquise à l'avance lorsque le pneu d'aéronef (32) est neuf et le taux d'usure prédit.

5. Procédé de prédiction d'état d'usure selon l'une quelconque des revendications 1 à 4, dans lequel les données de température de l'air se rapportant à l'aéronef (31) sont acquises par un capteur installé sur l'aéronef.

6. Procédé de prédiction d'état d'usure selon l'une quelconque des revendications 1 à 5, dans lequel le modèle est généré en utilisant l'algorithme prédéterminé à l'aide des données de température de l'air se rapportant à l'aéronef (31) et des données d'accélération de l'aéronef (31) acquises à l'avance comme variables explicatives.

7. Procédé de prédiction d'état d'usure selon la revendication 5, dans lequel les données de température de l'air se rapportant à l'aéronef (31) sont une moyenne d'une partie des données de température de l'air pour chaque vol.

8. Dispositif de prédiction d'état d'usure (10) pour prédire un état d'usure d'un pneu d'aéronef (32), comprenant :
une unité de génération de modèle (124) qui génère un modèle de prédiction de l'état d'usure en tant que variable objective en utilisant un algorithme prédéterminé dans lequel des données de température de l'air se rapportant à un aéronef (31) acquises à l'avance, les données de température de l'air étant mesurées par un capteur installé sur l'aéronef (31) ou étant les données de température de l'air à un aéroport, sont définies comme une variable explicative ; et
une unité de prédiction qui saisit les données de température de l'air dans le modèle généré par l'unité de génération de modèle et prédit l'état d'usure, dans lequel
les données de température de l'air se rapportant à l'aéronef (31) sont définies comme premières données de température de l'air ; et
l'unité de prédiction saisit des données incluant des secondes données de température de l'air qui sont postérieures à un temps de prédiction et aux premières données de température de l'air dans le modèle, et prédit l'état d'usure.

9. Programme de prédiction d'état d'usure pour prédire un état d'usure d'un pneu d'aéronef, le programme de prédiction d'état d'usure amène un ordinateur du dispositif terminal à exécuter les étapes consistant à :
générer un modèle de prédiction de l'état d'usure en tant que variable objective en utilisant un algorithme prédéterminé dans lequel des données de température de l'air se rapportant à un aéronef (31) acquises à l'avance, les données de température de l'air étant mesurées par un capteur installé sur l'aéronef (31) ou étant les données de température de l'air à un aéroport, sont définies comme une variable explicative ; et
saisir les données de température de l'air dans le modèle et prédire l'état d'usure, dans lequel
les données de température de l'air se rapportant à l'aéronef (31) sont définies comme premières données de température de l'air ; et
lors de la prédiction de l'état d'usure, des données incluant des secondes données de température de l'air qui sont postérieures à un temps de prédiction et aux premières données de température de l'air sont saisies dans le modèle et l'état d'usure est prédit.
